(19) **Europäisches Patentamt / European Patent Office / Office européen des brevets**

(11) **EP 3 285 204 A1**

(12) **EUROPEAN PATENT APPLICATION**
published in accordance with Art. 153(4) EPC

(43) Date of publication:
**21.02.2018 Bulletin 2018/08**

(51) Int Cl.:
***G06K 9/00*** (2006.01)

(21) Application number: **16892937.0**

(22) Date of filing: **13.06.2016**

(86) International application number:
**PCT/CN2016/085613**

(87) International publication number:
**WO 2017/214820 (21.12.2017 Gazette 2017/51)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Shenzhen Goodix Technology Co., Ltd.**
**Shenzhen, Guangdong 518045 (CN)**

(72) Inventors:
• **DU, Canhong**
  **Shenzhen**
  **Guangdong 518045 (CN)**
• **YI, Fujian**
  **Shenzhen**
  **Guangdong 518045 (CN)**

(74) Representative: **Würmser, Julian**
  **Meissner Bolte Patentanwälte**
  **Rechtsanwälte Partnerschaft mbB**
  **Postfach 86 06 24**
  **81633 München (DE)**

(54) **TOUCH DETECTION CIRCUIT, FINGERPRINT MODULE AND CONTROL METHOD THEREOF**

(57) The present application relates to display technologies, and discloses a touch detection circuit, a fingerprint module, and a control method thereof. In the present application, the fingerprint module specifically includes a fingerprint sensor, a metal decorative part, a touch detection circuit, and a processing unit; the touch detection circuit generates a first trigger signal when the metal decorative part is touched; the processing unit is connected to the touch detection circuit and the fingerprint sensor; the processing unit generates a finger touch signal when the first trigger signal generated by the touch detection circuit and/or the fingerprint sensing signal generated by the fingerprint sensor is received. The present application also provides a control method of fingerprint module. In the present application, the metal decorative part and the fingerprint sensor are cooperatively used for performing a joint detection and the overall detection range of the fingerprint module is increased, thereby reducing the detection blind area of a finger and improving the detection accuracy of the fingerprint module for realizing a touch detection function.

FIG. 2

Printed by Jouve, 75001 PARIS (FR)

**Description**

**TECHNICAL FIELD**

The present application relates to fingerprint recognition technologies, and more particularly to a touch detection circuit, a fingerprint module and a control method of the fingerprint module.

**BACKGROUND**

Intelligent terminal equipment has been greatly popularized with the rapid development of mobile communication. The fingerprint recognition technology has extensively used in the field of intelligent terminal equipment.

At present, a fingerprint module is usually arranged under a screen of the intelligent terminal equipment, and in addition to a fingerprint identification function, the fingerprint module also provide a touch detection function. That is, the fingerprint module can determine a touch event by judging whether or not a fingerprint of a user's finger is detected.

However, due to a limited size of the intelligent terminal equipment, the fingerprint module is generally small, and a size of a fingerprint sensor thereof is usually smaller than that of a finger. If the finger is not in place, it is likely not to be detected. In other words, a finger detection blind area may exist, thereby decreasing the touch detection accuracy.

**SUMMARY**

An object of the present invention is to provide a touch detection circuit, a fingerprint module and a control method thereof. A metal decorative part and a fingerprint sensor are cooperatively used for performing a joint detection, which increases the overall detection range of the fingerprint module, and reduces the detection blind area of a finger, thereby improving the detection accuracy of the fingerprint module for realizing a touch detection function.

To solve the above technical problems, some embodiments of the present application provide a fingerprint module including: a fingerprint sensor, a metal decorative part, a touch detection circuit and a processing unit; the metal decorative part surrounds the fingerprint sensor; the touch detection circuit is connected to the metal decorative part; the touch detection circuit generates a first trigger signal when the metal decorative part is touched; the processing unit is connected to the touch detection circuit and the fingerprint sensor; wherein the processing unit generates a finger touch signal when the first trigger signal generated by the touch detection circuit and/or the fingerprint sensing signal generated by the fingerprint sensor is received.

Some embodiments of the present application provide a touch detection circuit including: a driving signal source, a driving resistor, an operational amplifier, and an analog-to-digital converter; a first input of the operational amplifier is connected to the metal decorative part, the first input is further connected to the driving signal source via the driving resistor; an input of the analog-to-digital converter is connected to an output of the operational amplifier, and an output of the analog-to-digital converter is connected to the processing unit.

Some embodiments of the present application provide a touch detection circuit including: a voltage source, a first switch, a second switch, a third switch, a capacitor, an operational amplifier, and an analog-to-digital converter, the first switch is connected between the metal decorative part and a first input of the operational amplifier, the second switch is connected between the metal decorative part and the voltage source; the third switch is connected in parallel with the capacitor between the first input of the operational amplifier and an output of the operational amplifier; an input of the analog-to-digital converter is connected to the output of the operational amplifier, an output of the analog-to-digital converter is connected to the processing unit; wherein the control terminals of the first switch, the second switch, and the third switch respectively receive a control signal to realize switching on and switching off.

Some embodiments of the present application provide a control method of fingerprint module that is applied to the fingerprint module; the control method of fingerprint module includes: switching the processing unit to a touch detection mode when the touch operation signal is received by the processing unit; in the touch detection mode, generating by the processing unit a finger touch signal when a first trigger signal generated by the touch detection circuit and/or a fingerprint sensing signal generated by the fingerprint sensor is received by the processing unit; switching the processing unit to a fingerprint recognition mode when the fingerprint operation signal is received by the processing unit; in the fingerprint recognition mode, receiving by the processing unit the fingerprint sensing signal generated by the fingerprint sensor and generating by the processing unit a fingerprint image signal.

Compared to the known techniques, in some embodiments of the present application the metal decorative part surrounds the fingerprint sensor; the touch detection circuit is connected to the metal decorative part; the touch detection circuit generates a first trigger signal when the metal decorative part is touched; the processing unit is connected to the touch detection circuit and the fingerprint sensor; the processing unit generates a finger touch signal when the first trigger signal generated by the touch detection circuit and/or the fingerprint sensing signal generated by the fingerprint sensor is received. In summary, a finger touch can be sensed when the metal decorative part is connected to the touch circuit, that is, the metal decorative part and the fingerprint sensor can be cooperatively used for performing a joint detection, which increases the overall detection range of the fingerprint module is increased, and reduces the detection blind area of a finger, thereby improving the detection accuracy of the fingerprint module for realizing a touch detection function.

Additionally, the processing unit includes: a fingerprint recognition chip; the fingerprint recognition chip is connected to the touch detection circuit and the fingerprint sensor; wherein the fingerprint recognition chip generates the finger touch signal when the first trigger signal generated by the touch detection circuit and/or the fingerprint sensing signal generated by the fingerprint sensor is received. That is, other processing functions can be realized by only changing the software on the fingerprint chip; and, the touch detection circuit and the fingerprint recognition chip can be integrated together and can be packaged as a whole. Thus, the space for arranging elements can be saved, and it is advantageous for the miniaturization of intelligent terminal equipment.

Additionally, the processing unit includes: a fingerprint recognition chip and a microprocessor; the fingerprint recognition chip is connected to the fingerprint sensor; the microprocessor is connected to the touch detection circuit and the fingerprint recognition chip; wherein the fingerprint recognition chip generates a second trigger signal when the fingerprint sensing signal is received; the microprocessor generates the finger touch signal when the first trigger signal and/or the second trigger signal is received. That is, a microprocessor for receiving the first trigger signal and/or the second trigger signal is added. Therefore, in the implementation of the present aspect, an existing fingerprint chip (i.e., no change is made to the existing fingerprint chip)is combined with a new added microprocessor to achieve all processing functions of the fingerprint module, thereby being easier to make and having a shorter manufacturing cycle.

Additionally, the touch detection circuit includes: a driving signal source, a driving resistor, an operational amplifier, and an analog-to-digital converter; a first input of the operational amplifier is connected to the metal decorative part, the first input further is connected to the driving signal source via the driving resistor; an input of the analog-to-digital converter is connected to an output of the operational amplifier, and an output of the analog-to-digital converter is connected to the processing unit. As described above, a specific example of the touch detection circuit is provided.

Additionally, the driving signal source is further connected to the processing unit; wherein the processing unit switches on or off the driving signal source. The driving signal source switches on or off under control of a microprocessor, and when the processing unit is in a fingerprint recognition mode, the microprocessor sets the output voltage of the driving signal source to zero, thus avoiding a crosstalk caused by the coupling between the driving signal source and a fingerprint sensing electrode.

Additionally, the touch detection circuit includes a voltage source, a first switch, a second switch, a third switch, a capacitor, an operational amplifier, and an analog-to-digital converter; the first switch is connected between the metal decorative part and a first input of the operational amplifier, the second switch is connected between the metal decorative part and the voltage source; the third switch is connected in parallel with the capacitor between a first input of the operational amplifier and an output of the operational amplifier; an input of the analog-to-digital converter is connected to the output of the operational amplifier, an output of the analog-to-digital converter is connected to the processing unit; wherein the control terminals of the first switch, the second switch, and the third switch respectively receive a control signal to realize switching on and switching off. As described above, another specific implementation of the touch detection circuit is provided.

Additionally, the touch detection circuit further includes: a timing circuit unit; the timing circuit unit includes three control terminals which are respectively connected to the control terminals of the first switch, the second switch, and the third switch. The timing circuit unit realizes control of the first switch, the second switch, and the third switch.

**BRIEF DESCRIPTION OF THE DRAWINGS**

Fig. 1 is a schematic diagram of a fingerprint module applied to a smartphone according to a first embodiment of the present application;
Fig. 2 is a schematic block diagram of a fingerprint module according to a first embodiment of the present application;
Fig. 3 is a specific schematic diagram of a touch detection circuit according to a first embodiment of the present application;
Fig. 4 is a specific schematic diagram of a touch detection circuit according to a second embodiment of the present application;
Fig. 5 is a schematic block diagram of a fingerprint module according to a third embodiment of the present application; and
Fig.6 is a flowchart of a control method of fingerprint module according to a sixth embodiment of the present application.

**DETAILED DESCRIPTION**

To make the purposes, technical aspects and advantages of the present invention more clear, embodiments of the present application will be described in detail with reference to the accompanying drawings. However, it will be understood by those skilled in the art that many technical details have been presented in various embodiments of the present application in order to provide a better understanding of the present application. However, the technical solutions as claimed by the present application may be implemented without these technical details and variations and modifications based on the following embodiments.

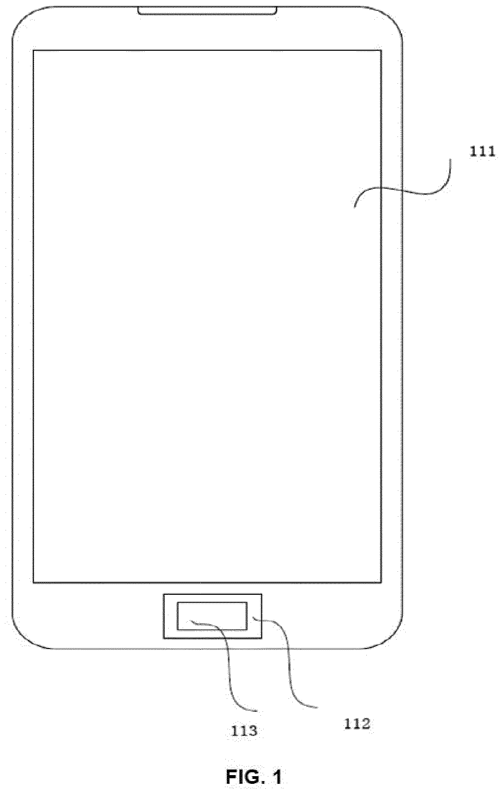

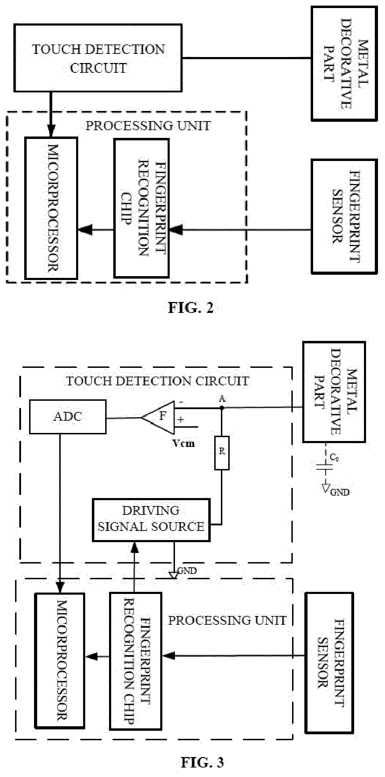

A first embodiment of the present application relates to a fingerprint module that is applied toa smart terminal equipment, such as a smartphone. Fig. 1 shows a schematic diagram of a fingerprint module applied to a smartphone, Fig. 2 is a schematic block diagram of a fingerprint module. Referring to Figs. 1 and 2, the fingerprint module specifically includes a fingerprint sensor, a metal decorative part, a touch detection circuit and a processing unit.

As shown in Fig. 1, the fingerprint module is provided in the lower area of a screen 111 of the smart phone. A metal decorative part 112 and a fingerprint sensor 113 are provided on a surface of the smart phone, and the metal decorative part 112 surrounds the fingerprint sensor 113 to protect and decorate the fingerprint sensor 113; the metal decorative part 112 on the smart phone is generally annular, and matches with a shape of the fingerprint sensor 113. In the present embodiment, the fingerprint sensor 113 includes a sensing electrode and a protective layer, and the protective layer is in direct contact with a user's finger.

As shown in Fig. 2, the touch detection circuit is connected to the metal decorative part; the processing unit is connected to the touch detection circuit and the fingerprint sensor. Specifically, the processing unit in the present embodiment includes a microprocessor and a fingerprint recognition chip, the fingerprint recognition chip is connected to the fingerprint sensor, and the microprocessor is connected to the touch detection circuit and the fingerprint recognition chip.

It should be noted that the microprocessor and the fingerprint recognition chip can be classified as a processing unit according to their functions in the present embodiment. In fact, the fingerprint recognition chip, the fingerprint sensor, and the metal decorative part can be a ready-made component (i.e., an existing fingerprint module).Accordingly, in the present embodiment, a touch detection circuit and a microprocessor (which cooperatively constitute an auxiliary chip) are actually newly added. That is, in the present embodiment, an existing fingerprint chip (i.e., no change is made to the existing fingerprint chip)is combined with the newly added touch detection circuit and microprocessor to achieve all processing functions of the fingerprint module, thereby being easier to make and having a shorter manufacturing cycle.

The fingerprint module of the present embodiment operates as follows. A user's finger touches the fingerprint module, and if the metal decorative part is touched, the touch detection circuit generates a first trigger signal. If the fingerprint sensor is touched, the fingerprint sensor generates a fingerprint sensing signal, and the fingerprint recognition chip generates a second trigger signal based on the fingerprint sensing signal. When the microprocessor receives at least one of the first trigger signal and the second trigger signal, the microprocessor generates a finger touch signal, which indicates that the touch operation of the user's finger is sensed.

Therefore, when a touch operation is performed by a user, the microprocessor can generate a finger touch signal, as long as any of the sensor area and the metal decorative part of the fingerprint sensor is touched, perhaps due to differences in finger size or touch position. That is, the metal decorative part and the fingerprint sensor are cooperatively used for performing a joint detection, and an overall detection range of the fingerprint module is increased, thereby reducing the detection blind area of a finger and improving the detection accuracy of the fingerprint module for realizing a touch detection function.

As shown in Fig. 3, the touch detection circuit in the present embodiment specifically includes a driving signal source, a driving resistor R, an operational amplifier F, and an analog-to-digital converter ADC. The first input of the operational amplifier F is connected to the metal decorative part, and is connected to a driving signal source via the driving resistor R; the second input of the operational amplifier F is connected to a reference voltage Vcm; the first input of the operational amplifier F of the present embodiment is a negative phase input and the second input of the operational amplifier F of the present embodiment is a positive phase input. The input of the analog-to-digital converter ADC is connected to an output of the operational amplifier F, and the output of the analog-to-digital converter ADC is connected to the microprocessor.

The finger touch detection principle of the touch detection circuit in the present embodiment is as follows.

When the metal decorative part is not touched by a finger, the driving resistor R and the parasitic capacitance $C_0$ of the metal decorative part with respect to the ground GND divide a driving voltage output by the driving signal source, and a voltage at point A (i.e., the first input of the operational amplifier F) is:

$$Ua = \frac{1}{\sqrt{1 + \left(\dfrac{R}{X_C}\right)^2}} \cdot U_S \qquad X_C = \frac{1}{2\pi f C_0}$$

In the above formula, Us is a voltage amplitude of the driving voltage, f is a frequency of the driving voltage, $X_c$ is a reactance of the capacitor $C_0$, and $C_0$ is a capacitance of the metal decorative part with respect to the ground GND.

Since a parasitic capacitance $\Delta C$ also exists between the finger and the ground, when the metal decorative part is touched, $\Delta C$ and $C_0$ are in parallel, and the voltage at point A becomes:

$$Ua' = \frac{1}{\sqrt{1 + \left(\dfrac{R}{X_C'}\right)^2}} \cdot U_S \qquad X_C' = \frac{1}{2\pi f (C_0 + \Delta C)}$$

In the above formula, $X'_c$ is a reactance of the capacitor $C_0$ when the metal decorative part is touched.

It can be seen that the voltage at point A becomes smaller when the metal decorative part is touched. The operational amplifier F amplifies the voltage at point A, and the amplified voltage is sampled by the analog-to-digital converter ADC and then is transmitted to the microprocessor, the microprocessor calculates the voltage at point A and determines whether the metal decorative part is touched according to variation of the voltage at point A.

Preferably, the driving signal source can be connected to the microprocessor, and the driving signal source can be switched on or off under control of the microprocessor. When the processing unit is in a fingerprint recognition mode, the microprocessor sets the output voltage of the driving signal source to zero, thus avoiding a crosstalk caused by coupling between the driving signal source and the sensing electrode.

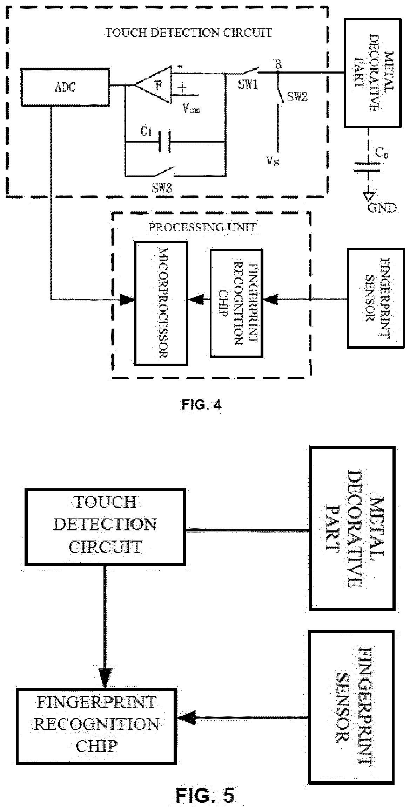

A second embodiment of the present application relates to a fingerprint module as shown in Fig. 4. Another example of a touch detection circuit is provided in the fingerprint module of the second embodiment. The touch detection circuit includes a voltage source Vs, a first switch SW1, a second switch SW2, a third switch SW3, a capacitor $C_1$, an operational amplifier F, and an analog-to-digital converter ADC. The first switch SW1 is connected between the metal decorative part and a first input of the operational amplifier F. The second switch SW2 is connected between the metal decorative part and the voltage source Vs. The third switch SW3 is connected in parallel with the capacitor $C_1$ between the first input of the operational amplifier F and an output of the operational amplifier F. A second input of the operational amplifier F is connected to the reference voltage Vcm. The first input of the operational amplifier F in the present embodiment is a negative phase input, and the second input of the operational amplifier F in the present embodiment is a positive phase input. An input of the analog-to-digital converter ADC is connected to an output of the operational amplifier F, and an output of the analog-to-digital converter ADC is connected to the microprocessor; and control terminals of the first switch SW1, the second switch SW2 and the third switch SW3 respectively receive control signals to realize switching on and off.

Preferably, the touch detection circuit in the present embodiment can further include a timing circuit unit. The timing circuit unit includes three control terminals which are connected to the control terminals of the first switch SW1, the second switch SW2, and the third switch SW3, respectively; that is, the timing circuit unit performs timing control on switching on and switching off the first switch SW1, the second switch SW2, and the third switch SW3.

A finger touch detection method of the touch detection circuit in the present embodiment can includes the following steps:

Step 1: When the touch detection circuit is not in operation, the third switch SW3 is switched on, the first switch SW1 is switched off, and the second switch SW2 is also switched on; an output voltage of the operational amplifier F is Vcm (i.e., the output voltage of the operational amplifier F is equal to the reference voltage).

Step 2: When the touch detection circuit starts to operate, the third switch SW3 is switched off.

Step 3: When SW2 is switched on, the voltage at point B is Vs.

Step 4: When SW1 is switched on, due to Vs≠Vcm, the capacitance Co of the metal decorative part with respect to the ground GND discharges to capacitor $C_1$ until a voltage at point B is equal to Vcm. In the discharge process, the charge of $C_0$ shifts to $C_1$ such that the voltages at both ends of $C_1$ change, and the following relationship is met:

$$\Delta U \times C_1 = (Vs - Vcm) \times C_0, \quad \Delta U = (Vs - Vcm) \times C_0 / C_1$$

Since the voltage at point B is stabilized to Vcm, the output voltage of the operational amplifier F has a variation Δ U.

Step 5: steps 3, 4 are repeatedly performed for N times (N can be set to any integer greater than 0) and the output voltage of the operational amplifier F is:

$$Vo = Vcm + N \times \Delta U = Vcm + N \times (Vs - Vcm) \times C_0 / C_1$$

When the metal decorative part is touched, the Co will be increased according to the description in the first embodiment, and the output voltage of the operational amplifier F will be changed according to the formula in step 5.The output voltage of the operational amplifier F is sampled by the analog-to-digital converter ADC and then is transmitted to the microprocessor. The microprocessor calculates the value of the voltage at point B and determines whether the metal decorative part is touched according to the change of the voltage at the point B.

A third embodiment of the present application relates to a fingerprint module as shown in Fig. 5. The third embodiment is substantially the same as the first or second embodiment, the main difference is that the processing unit of the first or second embodiment includes a microprocessor and a fingerprint recognition chip. The processing unit of the present embodiment includes a fingerprint recognition chip connected to a touch detection circuit and a fingerprint sensor.

In the present embodiment, the fingerprint recognition chip generates a finger touch signal when the first trigger signal generated by the touch detection circuit and/or the fingerprint sensing signal generated by the fingerprint sensor is received by the fingerprint recognition chip.

In the present embodiment, other processing functions can be realized by only changing software on the fingerprint chip; and, the touch detection circuit and the fingerprint recognition chip can be integrated together and can be packaged into one piece. Thus, a space for arranging elements can be saved, and it is advantageous for the miniaturization of intelligent terminal equipment.

A fourth embodiment of the present application relates to a touch detection circuit, and the touch detection circuit in the present embodiment is a touch detection circuit in the first embodiment.

A fifth embodiment of the present application relates to a touch detection circuit, and the touch detection circuit in the present embodiment is a touch detection circuit in the second embodiment.

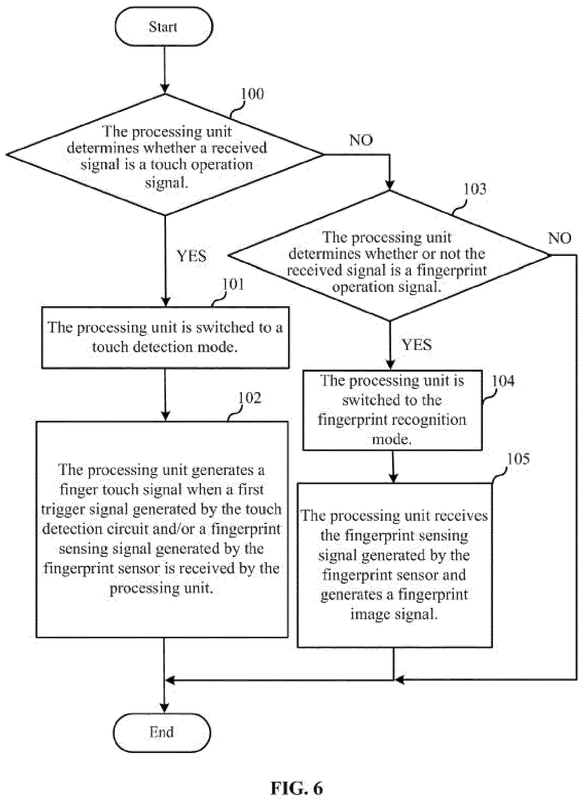

A sixth embodiment of the present application relates to a control method of fingerprint module. The specific process is shown in Fig. 6. The control method of fingerprint module includes:

Step S100: The processing unit determines whether a received signal is a touch operation signal. If yes, the process proceeds to step 101. If no, the process proceeds to step 103.

If the processing unit includes a fingerprint recognition chip, step S100 is executed by the fingerprint recognition chip.

If the processing unit includes a microprocessor and a fingerprint recognition chip, step S100 is executed by the microprocessor.

Step S101: The processing unit is switched to a touch detection mode.

If the processing unit includes a fingerprint recognition chip, t step S101 is executed by the fingerprint recognition chip.

If the processing unit includes a microprocessor and a fingerprint recognition chip, step S101 is executed by the microprocessor and the fingerprint recognition chip simultaneously. That is, the microprocessor and the fingerprint recognition chip are switched to the touch detection mode respectively.

Step S102: In the touch detection mode, the processing unit generates a finger touch signal when a first trigger signal generated by the touch detection circuit and/or a fingerprint sensing signal generated by the fingerprint sensor is received by the processing unit.

If the processing unit includes a fingerprint recognition chip, the fingerprint sensing signal generated by the fingerprint sensor is received by the fingerprint recognition chip. The fingerprint recognition chip generates a finger touch signal when the first trigger signal generated by the touch detection circuit and/or the fingerprint sensing signal generated by the fingerprint sensor is received by the fingerprint recognition chip.

If the processing unit includes a microprocessor and a fingerprint recognition chip, the second trigger signal is generated according to the fingerprint sensing signal when the fingerprint sensing signal generated by the fingerprint sensor is received by the fingerprint recognition chip. The microprocessor generates a finger touch signal when the first trigger signal generated by the touch detection circuit and/or the second trigger signal generated by the fingerprint recognition chip is received by the microprocessor.

Step S103: The processing unit determines whether or not the received signal is a fingerprint operation signal. If yes, the process proceeds to step 104, if no, the process is ended.

If the processing unit includes a fingerprint recognition chip, step S103 is executed by the fingerprint recognition chip.

If the processing unit includes a microprocessor and a fingerprint recognition chip, step S103 is executed by the microprocessor.

Step S104: The processing unit is switched to the fingerprint recognition mode.

If the processing unit includes a fingerprint recognition chip, step S104 is executed by the fingerprint recognition chip.

If the processing unit includes a microprocessor and a fingerprint recognition chip, step S104 is executed by the microprocessor and the fingerprint recognition chip simultaneously. That is, the microprocessor and the fingerprint recognition chip are switched to the touch detection mode respectively.

Step S105: In the fingerprint recognition mode, the processing unit receives the fingerprint sensing signal generated by the fingerprint sensor and generates a fingerprint image signal.

If the processing unit includes a fingerprint recognition chip, the fingerprint recognition chip receives the fingerprint sensing signal generated by the fingerprint sensor and generates a fingerprint image signal. Then, the fingerprint recognition chip transmits the fingerprint image signal to the main controller; the main controller is a main controller of an intelligent terminal device to which the fingerprint module is applied.

If the processing unit includes a microprocessor and a fingerprint recognition chip, the fingerprint recognition chip receives the fingerprint sensing signal generated by the fingerprint sensor and generates a fingerprint image signal; and the fingerprint image signal is transmitted to the main controller through the microprocessor. That is, in the fingerprint recognition mode, the microprocessor operates only as a transmission channel, without performing any operation on the fingerprint image signals.

The steps of the above methods are only for the sake of clarity of the description. The steps may be combined into one step or some steps may be divided into a plurality of steps, which shall fall within the scope of the present invention as long as a same logical relationship is included. All insignificant modifications to the algorithm or the process or the introduction of insignificant designs and the core design without changing the algorithm and process fall within the scope of the present invention.

The above-described exemplary embodiments explain the objectives, technical solutions and advantages of the present application in details, and it should be understood that the foregoing description is only the exemplary embodiments of the present application and is not intended to limit the scope of the present invention. Any modifications, equivalent substitutions, improvements, and the like that fall within the spirit and scope of the present invention are intended to be included in the scope of the present invention.

**Claims**

1. A fingerprint module, **characterized in that** the fingerprint module comprises:

   a fingerprint sensor, a metal decorative part, a touch detection circuit and a processing unit;
   wherein the metal decorative part surrounds the fingerprint sensor;
   wherein the touch detection circuit is connected to the metal decorative part, the touch detection circuit is configured to generate a first trigger signal when the metal decorative part is touched;
   wherein the processing unit is connected to the touch detection circuit and the fingerprint sensor, the processing unit is configured to generate a finger touch signal when the first trigger signal generated by the touch detection circuit and/or the fingerprint sensing signal generated by the fingerprint sensor is received.

2. The fingerprint module according to claim 1, **characterized in that** the processing unit comprises a fingerprint recognition chip, the fingerprint recognition chip is connected to the touch detection circuit and the fingerprint sensor; wherein the fingerprint recognition chip is configured to generate the finger touch signal when the first trigger signal generated by the touch detection circuit and/or the fingerprint sensing signal generated by the fingerprint sensor is received.

3. The fingerprint module according to claim 1, **characterized in that** the processing unit comprises:

   A fingerprint recognition chip and a microprocessor;
   wherein the fingerprint recognition chip is connected to the fingerprint sensor, the microprocessor is connected to the touch detection circuit and the fingerprint recognition chip;
   wherein the fingerprint recognition chip is configured to generate a second trigger signal when the fingerprint sensing signal is received;

the microprocessor is configured to generate the finger touch signal when the first trigger signal and/or the second trigger signal is received.

4. The fingerprint module according to claim 1, **characterized in that** the touch detection circuit comprises: a driving signal source, a driving resistor, an operational amplifier, and an analog-to-digital converter;
Wherein a first input of the operational amplifier is connected to the metal decorative part, the first input being further connected to the driving signal source via the driving resistor;
an input of the analog-to-digital converter is connected to an output of the operational amplifier, and an output of the analog-to-digital converter is connected to the processing unit.

5. The fingerprint module according to claim 4, **characterized in that** the driving signal source is further connected to the processing unit; wherein the processing unit is configured to switch on or off the driving signal source.

6. The fingerprint module according to claim 1, **characterized in that** the touch detection circuit comprises: a voltage source, a first switch, a second switch, a third switch, a capacitor, an operational amplifier, and an analog-to-digital converter;
wherein the first switch is connected between the metal decorative part and a first input of the operational amplifier, the second switch is connected between the metal decorative part and the voltage source;
the third switch is connected in parallel with the capacitor between the first input of the operational amplifier and an output of the operational amplifier;
an input of the analog-to-digital converter is connected to the output of the operational amplifier, an output of the analog-to-digital converter is connected to the processing unit;
the control terminals of the first switch, the second switch, and the third switch respectively receive a control signal for switching on and switching off.

7. The fingerprint module according to claim 6, **characterized in that** the touch detection circuit further comprises a timing circuit unit;
wherein the timing circuit unit includes three control terminals which are respectively connected to the control terminals of the first switch, the second switch, and the third switch.

8. A touch detection circuit, **characterized in that** the touch detection circuit is the touch detection circuit in the fingerprint module according to claim 4 or 5.

9. A touch detection circuit, **characterized in that** the touch detection circuit is the touch detection circuit in the fingerprint module according to claim 6 or 7.

10. A control method of a fingerprint module, **characterized in that** the control method is applied to a fingerprint module according to any one of claims 1 to 7, the control method of the fingerprint module comprising:

Switching a processing unit to a touch detection mode when a touch operation signal is received by the processing unit;
in the touch detection mode, generating, by the processing unit, a finger touch signal when a first trigger signal generated by a touch detection circuit and/or a fingerprint sensing signal generated by a fingerprint sensor is received by the processing unit;
switching the processing unit to a fingerprint recognition mode when a fingerprint operation signal is received by the processing unit;
in the fingerprint recognition mode, receiving, by the processing unit, the fingerprint sensing signal generated by the fingerprint sensor and generating a fingerprint image signal.

FIG. 1

TOUCH DETECTION
CIRCUIT

METAL
DECORATIVE
PART

PROCESSING UNIT

MICORPROCESSOR

FINGERPRINT
RECOGNITION
CHIP

FINGERPRINT
SENSOR

**FIG. 2**

TOUCH DETECTION CIRCUIT

METAL
DECORATIVE
PART

ADC

F

Vcm

A

R

$C_0$

GND

DRIVING
SIGNAL SOURCE

GND

MICORPROCESSOR

FINGERPRINT
RECOGNITION CHIP

PROCESSING UNIT

FINGERPRINT
SENSOR

**FIG. 3**

TOUCH DETECTION CIRCUIT

ADC

F

$V_{cm}$

$C_1$

SW1

B

SW2

$V_S$

SW3

METAL DECORATIVE PART

$C_0$

GND

PROCESSING UNIT

MICORPROCESSOR

FINGERPRINT RECOGNITION CHIP

FINGERPRINT SENSOR

**FIG. 4**

TOUCH DETECTION CIRCUIT

METAL DECORATIVE PART

FINGERPRINT RECOGNITION CHIP

FINGERPRINT SENSOR

**FIG. 5**

Start

100

The processing unit
determines whether a received
signal is a touch operation
signal.

NO

YES

101

The processing unit is switched to a
touch detection mode.

103

The processing unit
determines whether or not the
received signal is a fingerprint
operation signal.

NO

YES

104

The processing unit is
switched to the
fingerprint recognition
mode.

102

The processing unit generates a
finger touch signal when a first
trigger signal generated by the touch
detection circuit and/or a fingerprint
sensing signal generated by the
fingerprint sensor is received by the
processing unit.

105

The processing unit receives
the fingerprint sensing
signal generated by the
fingerprint sensor and
generates a fingerprint
image signal.

End

**FIG. 6**

# INTERNATIONAL SEARCH REPORT

| International application No. |
| --- |
| **PCT/CN2016/085613** |

**A. CLASSIFICATION OF SUBJECT MATTER**

G06K 9/00 (2006.01) i

According to International Patent Classification (IPC) or to both national classification and IPC

**B. FIELDS SEARCHED**

Minimum documentation searched (classification system followed by classification symbols)

G06K; G06F

Documentation searched other than minimum documentation to the extent that such documents are included in the fields searched

Electronic data base consulted during the international search (name of data base and, where practicable, search terms used)

CNABS, CNKI, SIPOABS, DWPI: GOODIX, amplify, modulus, fingerprint, ring, cycle, identify, sense, detect, touch, hand, amplifier, ADC

**C. DOCUMENTS CONSIDERED TO BE RELEVANT**

| Category* | Citation of document, with indication, where appropriate, of the relevant passages | Relevant to claim No. |
| --- | --- | --- |
| X | CN 205121587 U (SHENZHEN GOODIX TECHNOLOGY CO., LTD.), 30 March 2016 (30.03.2016), description, paragraphs 0030-0055 | 1-3, 10 |
| A | CN 205121587 U (SHENZHEN GOODIX TECHNOLOGY CO., LTD.), 30 March 2016 (30.03.2016), description, paragraphs 0030-0055 | 4-9 |
| A | CN 105117684 A (SHENZHEN GOODIX TECHNOLOGY CO., LTD.), 02 December 2015 (02.12.2015), the whole document | 1-10 |
| A | W0 2016/058122 A1 (SHENZHEN GOODIX TECHNOLOGY CO., LTD.), 21 April 2016 (21.04.2016), the whole document | 1-10 |
| A | CN 103942538 A (NANCHANG O-FILM BIO-IDENTIFICATION TECHNOLOGY CO., LTD. et al.), 23 July 2014 (23.07.2014), the whole document | 1-10 |
| E | CN 106462751 A (SHENZHEN HUIDING TECHNOLOGY CO., LTD.), 22 February 2017 (22.02.2017), claims 1-10 | 1-10 |

☐ Further documents are listed in the continuation of Box C.          ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 06 March 2017 (06.03.2017) | **17 March 2017 (17.03.2017)** |

| Name and mailing address of the ISA/CN: State Intellectual Property Office of the P. R. China No. 6, Xitucheng Road, Jimenqiao Haidian District, Beijing 100088, China Facsimile No.: (86-10) 62019451 | Authorized officer **HAN, Yan** Telephone No.: (86-10) **62411701** |
| --- | --- |

Form PCT/ISA/210 (second sheet) (July 2009)

## INTERNATIONAL SEARCH REPORT
### Information on patent family members

| International application No. |
| --- |
| **PCT/CN2016/085613** |

| Patent Documents referred in the Report | Publication Date | Patent Family | Publication Date |
| --- | --- | --- | --- |
| CN 205121587 U | 30 March 2016 | None | |
| CN 105117684 A | 02 December 2015 | WO 2017016102 A1 | 02 February 2017 |
| WO 2016/058122 A1 | 21 April 2016 | US 2016350577 A1 | 01 December 2016 |
| | | CN 105981040 A | 28 September 2016 |
| | | EP 3090384 A1 | 09 November 2016 |
| | | IN 201617026694 A | 31 August 2016 |
| CN 103942538 A | 23 July 2014 | None | |
| CN 106462751 A | 22 February 2017 | None | |

Form PCT/ISA/210 (patent family annex) (July 2009)